(19) **Europäisches Patentamt / European Patent Office / Office européen des brevets**

(11) **EP 1 538 750 B1**

(12) **EUROPEAN PATENT SPECIFICATION**

(45) Date of publication and mention
of the grant of the patent:
**02.06.2010 Bulletin 2010/22**

(51) Int Cl.:
***H03J 1/00*** (2006.01)

(21) Application number: **04028089.3**

(22) Date of filing: **25.11.2004**

(54) **Receiver**

Empfänger

Récepteur

(84) Designated Contracting States:
**DE FR GB**

(30) Priority: **03.12.2003 JP 2003405024**

(43) Date of publication of application:
**08.06.2005 Bulletin 2005/23**

(73) Proprietor: **Pioneer Corporation
Meguro-ku,
Tokyo (JP)**

(72) Inventors:
• **Yamamoto, Yuji
Kawagoe Koujou
Kawagoe-shi
Saitama-ken 350-8555 (JP)**

• **Kubuki, Toshiaki
Kawagoe Koujou
Kawagoe-shi
Saitama-ken 350-8555 (JP)**

(74) Representative: **Bohnenberger, Johannes et al
Meissner, Bolte & Partner GbR
Widenmayerstrasse 48
80538 München (DE)**

(56) References cited:
**WO-A-96/39750      WO-A-02/093807
JP-A- 2 170 626      JP-A- 3 159 424
US-A- 6 002 925**

EP 1 538 750 B1

**Description**

BACKGROUND OF THE INVENTION

The present invention relates to a receiver which receives, for example, an FM-modulated signal or a phase-modulated signal, and particularly to a receiver which is equipped with a multipass removal filter for removing a multipass distortion.

Conventionally, there has been suggested a receiver capable of improving its reception performance by using a multipass removal filter to remove a multipass distortion.

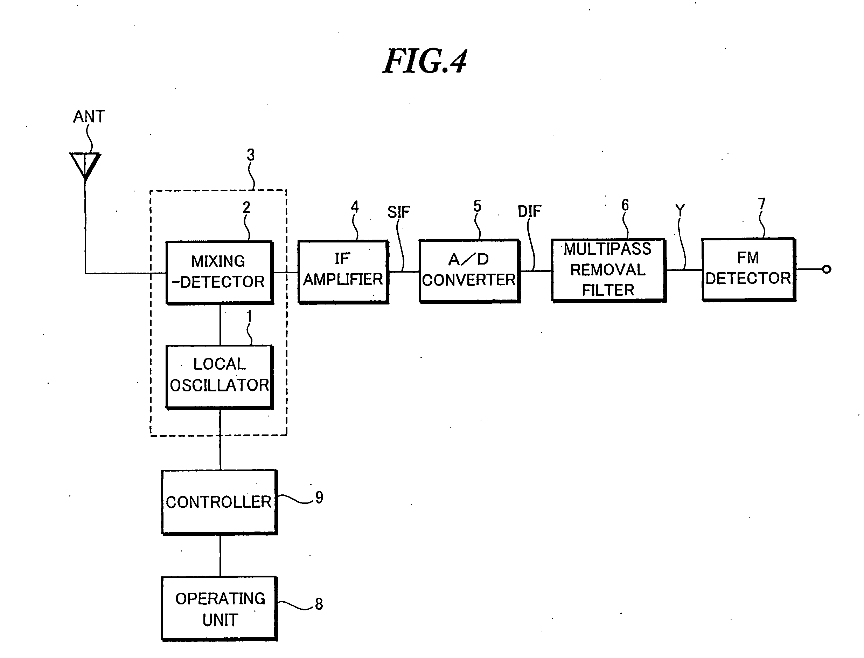

Upon referring to Fig.4 to explain the structure of this receiver, it will be understood that a high frequency input signal received by a reception antenna ANT will first enter a frequency conversion unit (front end unit ) 3. Then, a mixing detector (mixer) 2 performs mixing detection on the received signal in accordance with a local oscillation signal outputted from a local oscillator 1, thereby generating an intermediate frequency signal. Further, the intermediate frequency signal is amplified by an IF amplifier 4 to a level capable of signal processing, thus producing an amplified intermediate frequency signal SIF. Afterwards, the amplified intermediate frequency signal SIF is converted by an A/D converter 5 into a digital signal, thereby obtaining an intermediate frequency signal DIF consisting of a digital data sequence, which is then applied to a multipass removal filter 6.

The multipass removal filter 6 digital-filters the intermediate frequency signal DIF so as to output a multipass distortion eliminated signal (hereinafter, referred to as "desired signal") Y which is then FM detected by an FM detector 7 formed by a digital circuit.

When an operating unit 8 is operated to automatically select a broadcasting station or the like which allows a user to receive its broadcasting, a controller 9 starts a seeking control on the local oscillator 1 to continuously and rapidly change the frequency of the local oscillation signal, and successively store the frequency of each local oscillation signal in a memory or the like whenever the reception sensitivity is in good condition, thereby effecting an automatic tuning (selection of broadcasting stations).

However, with the above-described conventional receiver, during an automatic tuning (selection of broadcasting stations), there is a possibility that the reception sensitivity varies with respect to the frequency of the local oscillation signal changing continuously and rapidly, thus causing a sudden change in the intermediate frequency signal DIF generated as a result of the aforementioned mixing detection. For this reason, the intermediate frequency signal DIF changing rapidly will be inputted into the multipass removal filter 6, hence placing the multipass removal filter 6 in an unstable condition.

Further, with regard to a receiver whose reception position changes with a moving object such as an automobile vehicle, if an automobile vehicle travels through mountainous regions or the like where the reception sensitivity always changes from time to time, there is a possibility that the intermediate frequency signal DIF will have a sudden change, hence placing the multipass removal filter 6 in an unstable condition, as in the above-described automatic tuning (selection of broadcasting stations).

US-A-6 002 925 discloses a receiver comprising a front end unit for mixing/detecting, in accordance with a local oscillation signal, a high frequency received signal received by a reception antenna, thus outputting an intermediate frequency signal; an A/D converter for analog-digital converting the intermediate frequency signal, thereby outputting a digital intermediate frequency signal and an amplitude adjuster for adjusting the amplitude of the digital intermediate frequency signal to a predetermined value.

SUMMARY OF THE INVENTION

The present invention has been accomplished to solve the above problem, and it is an object of the invention to provide an improved receiver capable of stabilizing the multipass removal filter and thus ensuring an acceptable reception performance, without being affected by a change in the reception sensitivity.

In one aspect of the present invention, there is provided a receiver comprising: a front end unit for mixing/detecting, in accordance with a local oscillation signal, a high frequency received signal received by a reception antenna, thus outputting an intermediate frequency signal; an A/D converter for analogue-digital converting the intermediate frequency signal, thereby outputting a digital intermediate frequency signal; an amplitude adjuster for adjusting the amplitude of the digital intermediate frequency signal to a predetermined value and then outputting the digital intermediate frequency signal; a multipass removal filter for removing a multipass distortion of a signal outputted from the amplitude adjuster and then outputting the signal; and an amplitude supervisor for supervising a change in the signal outputted from the amplitude adjuster, and changing an adjusting period of the amplitude adjuster once the change exceeds a predetermined value.

BRIEF DESCRIPTION OF THE DRAWINGS

These and other objects and advantages of the present invention will become clear from the following description with reference to the accompanying drawings, wherein:

Fig. 1 is a block diagram showing the constitution of a receiver formed according to an embodiment of the present invention;
Fig. 2 is a block diagram showing the constitution of a multipass removal filter shown in Fig. 1;
Figs. 3A to 3C are graphs showing the functions of an amplitude adjuster and an amplitude supervisor shown in Fig. 1; and
Fig. 4 is a block diagram briefly showing the constitution of a conventional receiver.

DETAILED DESCRIPTION OF THE PREFERRED EMBODIMENTS

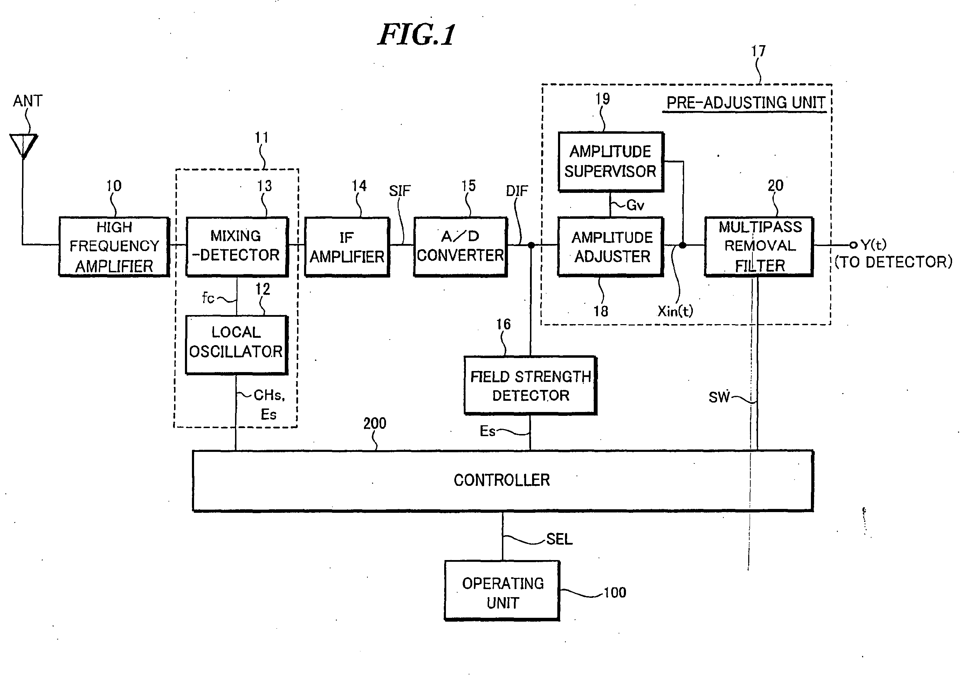

Next, as a preferred embodiment of the present invention, a receiver for receiving an FM broadcasting and the like will be described with reference to the accompanying drawings. Fig. 1 is a block diagram showing the constitution of the receiver formed according to the preferred embodiment.

Referring to Fig.1, the receiver of the present invention comprises a controller 200 containing a microprocessor (MPU) for executing a centralized control on the whole receiver, in response to a user's operation performed at the operating unit 100.

Further, the receiver includes a front end unit 11 for generating an intermediate frequency signal by mixing/ detecting a high frequency received signal received by the reception antenna ANT and amplified by a high frequency amplifier 10.

The front end unit 11 comprises a local oscillator 12 and a mixing detector 13. The local oscillator 12 generates a local oscillation signal $f_c$ having a frequency specified by the controller 200 which will be described later, while the mixing detector 13, in accordance with the local oscillation signal $f_c$, performs mixing detection on a high frequency signal outputted from the high frequency amplifier 10, thus outputting an intermediate frequency signal.

Moreover, the local oscillator 12 is provided with a PPL ( Phase locked loop) circuit which receives, through the controller 200, a field strength signal Es outputted from a field strength detector 16 which will be described later, performs a PLL control in accordance with the value of the field strength signal Es, such that the frequency of a local oscillation signal $f_c$ will be within a predetermined lock range, thereby outputting a local oscillation signal having a frequency specified by the controller 200.

Further, the receiver of the present invention also includes an IF amplifier 14 for amplifying an intermediate frequency signal outputted from the mixing detector 13 to a level capable of signal processing, and an A/D converter 15 for analog-digital converting the amplified intermediate frequency signal SIF and thus generating and outputting an intermediate frequency signal DIF consisting of a digital data sequence.

The A/D converter 15 is a $\Delta\Sigma$ modulation type A/D converter capable of high speed processing. Although the sampling frequency of the A/D converter 15 can be freely set, the present embodiment requires that such sampling frequency be 4 times the frequency of a carrier wave.

The output of the A/D converter 15 is coupled to a field strength detector 16 and a pre-adjusting unit 17. The pre-adjusting unit 17 includes an amplitude adjuster 18, an amplitude supervisor 19, and a multipass removal filter 20.

The field strength detector 16 AM-detects the intermediate frequency signal DIF outputted from the A/D converter 15, or at first performs AM-detection and then computes an effective value, so as to generate a field strength detection signal Es representing the field strength of an electric wave arriving at the reception antenna ANT and supply the same to the controller 200 and the local oscillator 12.

The amplitude adjuster 18 is formed by a so-called automatic gain control circuit (AGC circuit) which operates to successively detect the value (amplitude) of each intermediate frequency signal DIF, and at the same time, to automatically change the self-gain in response to the amplitude of the intermediate frequency signal DIF, thereby adjusting the amplitude of the intermediate frequency signal DIF to a predetermined value, and thus outputting the adjusted intermediate frequency signal as an input signal $X_{in}(t)$ to be applied to the multipass removal filter 20.

Further, the amplitude adjuster 18 operates to change the respective periods $\tau$ (hereinafter, referred to as "adjusting periods") of each intermediate frequency signal DIF when their amplitudes are being detected and adjusted, in accordance with a command represented by a control signal $G_v$ fed from the amplitude supervisor 19.

Namely, the amplitude adjuster 18 at its normal operation regards a period T equal to an inverse number of the aforementioned sampling frequency as an adjusting period $\tau$, successively detects the amplitude of each intermediate frequency signal DIF, and automatically adjusts the amplitude of each intermediate frequency signal DIF to a predetermined value. One the other hand, when the control signal $G_v$ outputted from the amplitude supervisor 19 indicates that the adjusting period $\tau$ should be changed, the amplitude regulator 18 will operate in synchronism with the changed adjusting period τ to successively detect the amplitude of each intermediate frequency signal DIF, and adjust the amplitude of each intermediate frequency signal DIF to a predetermined value.

Namely, the amplitude adjuster 18, by changing the adjusting period τ, changes a follow-up speed at the time of performing an amplitude adjustment to the intermediate frequency signal DIF.

The amplitude supervisor 19 will at first detect the envelope of the input signal $X_{in}(t)$ outputted from the amplitude adjuster 18, and then, if the rate of change per unit time of the envelope exceeds a predetermined value, the amplitude supervisor 19 will operate to change the adjusting period τ of the amplitude adjuster 18 in accordance with the control signal $G_v$ outputted from the amplitude supervisor 19.

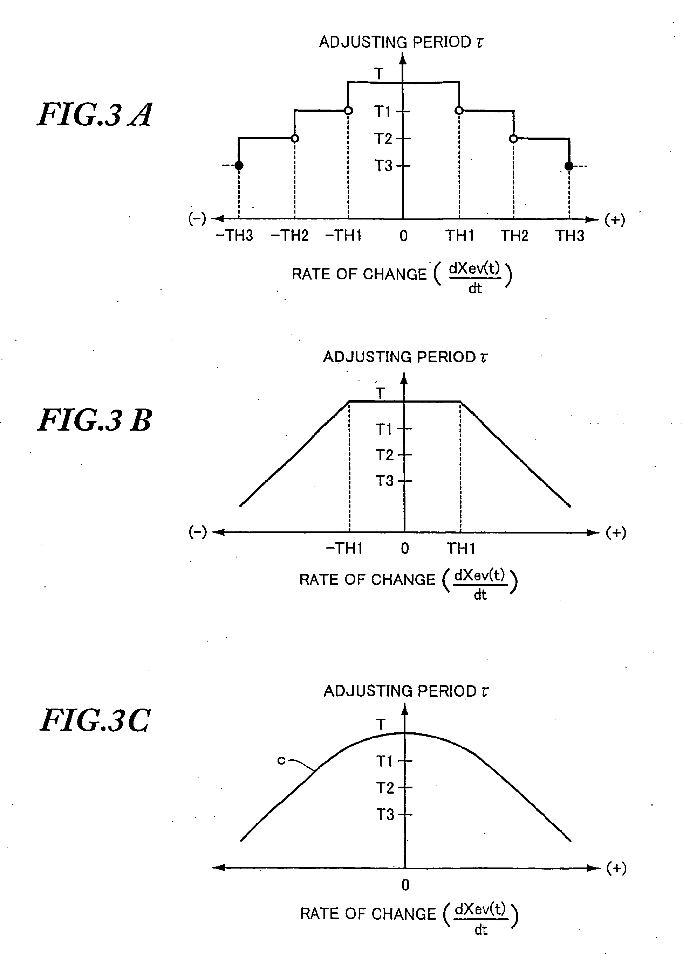

Here, if the envelope of an input signal $X_{in}(t)$ is expressed by $X_{ev}(t)$, the amplitude supervisor 19 will investigate $dX_{ev}(t)/dt$ which is a rate of change per unit time of the envelope $X_{ev}(t)$. Then, as shown in Fig. 3A which is a characteristic graph, if the rate of change $dX_{ev}(t)/dt$ is within a range of ±TH1 (TH1: threshold value), i.e., when $-TH1 \leq dX_{ev}(t)/dt \leq TH1$, the amplitude adjuster 18 will be specified by the amplitude supervisor 19 to set its adjusting period τ at a normal period T. On the other hand, if the rate of change $dX_{ev}(t)/dt$ is not within a range of ±TH1, i.e., when $-TH1 > dX_{ev}(t)/dt$ or $TH1 < dX_{ev}(t)/dt$, the amplitude supervisor 19 will operate to allow the adjusting period τ of the amplitude adjuster 18 to gradually (step by step) change to periods T1, T2, T3 .... smaller than the normal period T, in response to the rate of change $dX_{ev}(t)/dt$.

In this way, the amplitude supervisor 19, by comparing the rate of change $dX_{ev}(t)/dt$ with the predetermined threshold values ±TH1, ±TH2, and ±TH3 ..., operates to judge the follow-up ability of the amplitude adjuster 18 with respect to an amplitude change of an intermediate frequency signal DIF. In case where the amplitude adjuster 18 fails to follow up, the amplitude supervisor 19 will cause the amplitude adjuster 18 to automatically adjust its self-gain, in synchronism with an adjusting period τ equal to periods T1, T2, T3 ... predetermined corresponding to the above-mentioned respective threshold values TH1, ±TH2, and ±TH3 ...

Moreover, the amplitude supervisor 19 in advance stores as a look-up table a relation between the rate of change $dX_{ev}(t)/dt$ shown in Fig. 3A and the adjusting period τ, determines the adjusting period τ with reference to the look-up table in accordance with the rate of change $dX_{ev}(t)/dt$, and controls the amplitude adjuster 18 by the control signal $G_v$.

Although Fig. 3A shows a situation in which the adjusting period τ is gradually (step by step) changed with respect to the rate of change $dX_{ev}(t)/dt$, it is also possible to perform an operation shown in Fig. 3B. Namely, when the rate of change $dX_{ev}(t)/dt$ is within a range of ±TH1 (TH1: threshold value), the adjusting period τ is set at the normal period T. On the other hand, if the rate of change $dX_{ev}(t)/dt$ is not within a range of ±TH1, the adjusting period τ is changed in proportion to the rate of change $dX_{ev}(t)/dt$.

In addition, it is further possible to perform an operation shown in Fig. 3C. Namely, when a rate of change $dX_{ev}(t)/dt$ is about 0, the adjusting period τ is set at a normal period T. On the other hand, when the rate of change $dX_{ev}(t)/dt$ changes away from 0, it is allowed to perform a change in accordance with an adjusting period τ corresponding to a characteristic curve C determined in advance, in response to the value of the change rate $dX_{ev}(t)/dt$.

In this way, when the amplitude supervisor 19 controls the amplitude adjuster 18, if there is a sudden change in the field strength of a reception antenna ANT or if an automatic tuning (selection of broadcasting stations) is performed according to the requirement of a user, a sudden change in the amplitude of an intermediate frequency signal DIF will not hamper the following operation. Namely, when the adjusting period τ becomes short, the follow-up speed of the amplitude adjuster 18 with respect to the change of the intermediate frequency signal DIF will be increased, thereby inhibiting the change of the intermediate frequency signal DIF and supplying an input signal $X_{in}(t)$ having a predetermined amplitude to the multipass removal filter 20.

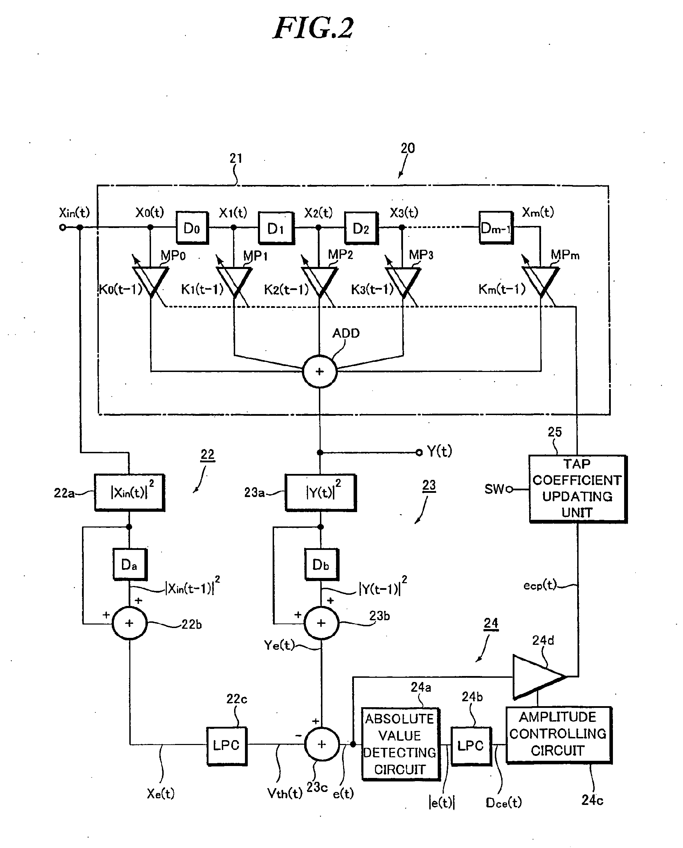

Next, the constitution of the multipass removal filter 20 will be explained with reference to a block diagram shown in Fig. 2.

The multipass removal filter 20 is constituted in a manner as shown in Fig. 2 which is a block diagram, including a digital filter 21, an envelope detecting section 22, an error detecting section 23, an error component restricting section 24, and a tap coefficient updating unit 25.

The digital filter 21 is comprised of an FIR digital filter or an IIR digital filter approximated by carrying out the Taylor development of the reverse characteristics of a propagation path until an electric wave arrives at an above-mentioned reception antenna. Further, with its tap coefficient being variable, the digital filter 21 generates and then outputs a desired signal (in other words, a predicted signal Y(t)) whose multipass distortion has been removed from an input signal $X_{in}(t)$.

Namely, while continuously delaying an input signal $X_{in}(t)$ by using m levels of delay elements Do - $D_{m-1}$ set as a delay time T equal to an inverse number of the above-mentioned sampling frequency, m multipliers $MP_0$ - $MP_m$ (m: number of taps) are operated to multiply, by the tap coefficients $K_0(t-1)$ - $K_m(t-1)$, the newest intermediate frequency signal $X_0(t)$ and the input signals $X_1(t-1)$ - $X_{m-1}(t-1)$ outputted from the delay elements $D_0$ - $D_{m-1}$, followed by using an adder ADD to add together m outputs of the multipliers $MP_0$ - $MP_{m-1}$, thereby generating and then outputting a desired signal Y(t) not containing multipass distortion.

The envelope detecting section 22 includes a computing unit 22a for computing the square $| X_{in}(t) |^2$ of the absolute value of an input signal $X_{in}(t)$, a delay element $D_a$ for delaying the output of the computing unit 22a by a delay time T and then outputting the output, an adder 22b for adding together the output value $| X_{in}(t) |^2$ of the computing unit 22a and the output value $| X_{in}(t-1) |^2$ of the delay element $D_a$ so as to output an envelope signal $X_e(t)$ indicating the envelope of the intermediate frequency signal $X_{in}(t)$, and a digital low-pass filter 22c which outputs a reference signal $V_{th}(t)$ of a direct current by smoothing the envelope signal $X_e(t)$.

That is, the envelope detecting section 22 generates and outputs the reference signal $V_{th}(t)$ of a direct current, in view of the fact that the amplitudes of an FM modulation signal and a phase modulation signal are constant from the beginning.

The error detecting section 23 includes a computing unit 23a for computing the square $Y(t) |^2$ of the absolute value of a desired signal Y(t) outputted from the digital filter 21 a delay element Db for delaying the output of the computing unit 23a by a delay time T and then outputting the output, an adder 23b for adding together the output value $| Y(t) |^2$ of the computing unit 23a and the output value $| Y(t-1) |^2$ of the delay element Db so as to output an envelope signal Ye(t) indicating the envelope of the desired signal Y(t), and a subtracter 23c for carrying out a subtraction processing to find an error component e(t) representing a difference between the envelope signal Ye(t) and the above-mentioned reference signal $V_{th}(t)$.

The error component restricting section 24 includes an absolute value detecting circuit 24a, a digital low-pass filter 24b, an amplitude controlling circuit 24c, and an amplitude restricting circuit 24d.

The absolute value detecting circuit 24a finds the absolute value $| e(t) |$ of the error component e(t), while the digital low-pass filter 24b generates and outputs a smoothed error component $D_{ce}(t)$ by smoothing the absolute value $|e(t)|$.

The amplitude controlling circuit 24c supervises the amplitude of an error component $D_{ce}(t)$ in detail. When the amplitude of the error component $D_{ce}(t)$ exceeds a predetermined value, the amplitude controlling circuit 24c controls the amplitude restricting circuit 24d so as to output a signal in which the amplitude of an error component e(t) has been inhibited, i.e., a corrected error component $e_{cp}(t)$. On the other hand, when the amplitude of the error component $D_{ce}(t)$ has not reached a predetermined value, the amplitude controlling circuit 24c controls the amplitude restricting circuit 24d so as to output an error component as a corrected error component $e_{cp}(t)$ without inhibiting the amplitude of the error component e(t).

Here, the amplitude restricting circuit 24d is formed by a digital attenuator or an amplifier, and changes an attenuation factor or an amplification factor in accordance with the control performed by the above-mentioned amplitude controlling circuit 24c, thereby outputting a corrected error component $e_{cp}(t)$ in which the amplitude of an error component e(t) has been inhibited.

If the amplitude restricting circuit 24d is formed by a digital attenuator and when the amplitude of an error component $D_{ce}(t)$ has not reached a predetermined value, the amplitude restricting circuit 24d will be controlled by the amplitude controlling circuit 24c so as to set its attenuation factor at 0 dB, thereby outputting an error component e(t) as a corrected error component $e_{cp}(t)$ without performing any correction. On the other hand, when the amplitude of the error component $D_{ce}(t)$ has exceeded the predetermined value, the amplitude restricting circuit 24d will be controlled by the amplitude controlling circuit 24c so as to increase its attenuation factor, thereby outputting a corrected error component $e_{cp}(t)$ with the amplitude of an error component e(t) inhibited.

If the amplitude restricting circuit 24d is formed by an amplifier and when the amplitude of an error component $D_{ce}(t)$ has not reached a predetermined value, the amplitude restricting circuit 24d will be controlled by the amplitude controlling circuit 24c so as to maintain its amplification factor at a predetermined standard amplification factor, thereby outputting an error component e(t) as a corrected error component $e_{cp}(t)$ without performing any correction. On the other hand, when the amplitude of the error component $D_{ce}(t)$ has exceeded the predetermined value, the amplitude restricting circuit 24d will be controlled by the amplitude controlling circuit 24c so as to reduce its amplification factor to a value lower than the standard amplification factor, thereby outputting a corrected error component $e_{cp}(t)$ with the amplitude of an error component e(t) inhibited.

Moreover, in the present embodiment, the amplitude controlling circuit 24c finds a logarithmic value of an error component $D_{ce}(t)$ which has exceeded a predetermined value, and then adjusts the attenuation factor or amplification factor of the amplitude restricting circuit 24d in accordance with a value proportional to the logarithmic value, thereby outputting a corrected error component $e_{cp}(t)$ with the amplitude of an error component e(t) inhibited.

The tap coefficient updating unit 25 receives, in synchronism with the delay time T, a corrected error component $e_{cp}(t)$ outputted from the amplitude restricting circuit 24d, variably and adaptively controls the tap coefficients $K_0(t-1)$ - $K_m(t-1)$ of the respective multipliers $MP_0$ - $MP_m$ in accordance with a tap coefficient updating algorithm expressed by the following equation (1), thereby converging the corrected error component $e_{cp}(t)$ or an error component e(t) outputted by the subtracter 23c to almost zero.

In fact, the following equation (1) expresses items of reflection wave components causing multipass distortion, which can be obtained by carrying out the Taylor development of the reverse characteristics of a propagation path until an electric wave arrives at a reception antenna ANT.

$$K_j(t) = K_j(t-1) - \alpha \cdot e_{cp}(t) \cdot \{X_j(t) \cdot Y(t) + X_j(t-1) \cdot Y(t-1)\} \quad \ldots (1)$$

(here, $j = 0, 1, 2, 3, ..., m-1$; $\alpha > 0$; t is a natural number representing a timing of each delay time T)

The multipass removal filter 20 constituted in the above-described manner, upon receiving an input signal $X_{in}$(t) , will repeat the above-discussed processing in synchronism with the aforementioned delay time T.

The digital filter 21, while continuously delaying an input signal $X_{in}$(t) by a delay time T based on m levels of delay elements $D_0$ - $D_{m-1}$, multiplies the same by the tap coefficients $K_0$(t-1) - $K_m$(t-1) of the multipliers $MP_0$ - $MP_m$, followed by adding together m outputs of the multipliers $MP_0$-$MP_m$ using an adder ADD, thereby generating a desired signal Y(t) and supplying the same to the FM detector 14.

Further, while generating the reference signal $V_{th}$(t) as an evaluation criterion in the above-mentioned envelope detecting section 22, the error detecting section 23 computes an error component e (t) between the reference signal $V_{th}$(t) and an envelope signal $Y_e$ (t) of the desired signal Y (t) , and generates a corrected error component $e_{cp}$ (t) with the amplitude of an error component e(t) inhibited by the error component restricting section 24. Subsequently, the tap coefficient updating unit 25 variably and adaptively controls the respective tap coefficients $K_0$(t) - $K_{m-1}$ (t) of the digital filter 21 in accordance with the tap coefficient updating algorithm expressed by the above equation (1) , thereby converging the corrected error component $e_{cp}$(t) or an error component e(t) to almost zero.

By virtue of the multipass removal filter 20, when the amplitude of an error component e (t) is likely to exceed a predetermined value, tap coefficients $K_0$(t-1) -$K_m$(t-1) will be variably controlled in accordance with a corrected error component $e_{cp}$(t) in which the amplitude of the error component e (t) has been inhibited, as shown in the above equation (1). In this way, the change of the tap coefficients $K_0$(t-1) -$K_m$(t-1) can be inhibited, making it possible to quickly converge the corrected error component $e_{cp}$ (t) or the error component e (t) to almost zero. Therefore, it is possible to stabilize the digital filter 21, thus realizing a strong (robust) multipass removal filter capable of performing a strong converging operation with respect to multipass.

In more detail, once the tap coefficient updating unit 25 performs a variable control on the tap coefficients $K_0$(t) - $K_{m-1}$(t) in accordance with the algorithm expressed by the above equation (1) , a time necessary for the converging will be decided depending on a predetermined coefficient value $\alpha$.

Here, since an error component e(t) outputted from the subtracter 23c is inputted to the digital low-pass filter 24b through the absolute value detector 24a, an error component $D_{ce}$ (t) will be gradually decided in accordance with the time constant characteristic of the digital low-pass filter 24b. Namely, during a period until a decided error component $D_{ce}$(t) is supplied to the amplitude restricting circuit 24c, in other words, during a period when the error component $D_{ce}$(t) has not yet been decided, since the amplitude of the error component e (t) is still small, a corrected error component $e_{cp}$ (t) will become almost equal to the error component e(t). Then, based on the corrected error component $e_{cp}$(t), once the tap coefficient updating unit 25 performs a variable control on the tap coefficients $K_0$ (t) -$K_{m-1}$(t) in accordance with the algorithm expressed by the above equation (1), it is possible to converge the corrected error component $e_{cp}$(t) or the error component e(t) at a velocity depending on the predetermined coefficient value $\alpha$, thereby making it possible to stabilize the digital filter 21.

On the other hand, when there is a possibility that a digital filter 21 becomes unstable due to an influence from multipass, after the passing of a time period decided by the time constant of the digital low-pass filter 14b, an error component $D_{ce}$(t) exceeding a predetermined amplitude will be decided and then supplied to the amplitude controlling circuit 24c. Therefore, the amplitude controlling circuit 24c controls the amplitude restricting circuit 24d so as to inhibit the amplitude of the error component e(t), thereby outputting the amplitude-inhibited signal as a corrected error component $e_{cp}$ (t) . Once, based on the corrected error component $e_{cp}$(t) having an inhibited amplitude, the tap coefficient updating unit 25 will perform a variable control on the tap coefficients $K_0$(t-1) - $K_m$(t-1) in accordance with the algorithm expressed by the above equation (1) , a multiplication value of the corrected error component $e_{cp}$(t) with the coefficient $\alpha$ will become small, hence substantially reducing the value of the coefficient $\alpha$. As a result, it is possible to shorten a time period necessary for converging the corrected error component $e_{cp}$ (t) or the error component e(t) to almost zero, thus stabilizing the digital filter 21.

In this way, the multipass removal filter 20 is constituted such that it can stably perform the converging operation with respect to multipass.

The tap coefficient updating unit 25 operates in accordance with a control signal SW supplied from the controller 200, and upon receiving a command for stopping the variable control of the tap coefficients $K_0$ (t-1) - $K_m$ (t-1) , fixes the tap coefficients $K_0$ (t-1) - $K_m$ (t-1) of the variable multipliers $MP_0$ — $MP_m$ to the latest tap coefficients controlled. Then, in accordance with the control signal SW, upon receiving a command for releasing the stopping, the variable control of the variable multipliers $MP_0$-$MP_{m-1}$, is restarted to variably control the tap coefficients $K_0$(t-1) - $K_m$(t-1) in accordance with the tap coefficient updating algorithm expressed by the above-mentioned equation (1).

The controller 200 performs a centralized control of the operation of the entire receiver as described above, and upon receiving, through the operating unit 100, an instruction from a user specifying a desired broadcasting station, searches a tuning data table (not shown) stored in advance in a memory, in accordance with a specifying signal SEL supplied from the operating unit 100, thereby detecting the frequency of the specified broadcasting station. Then, a local oscillation signal corresponding to the specified broadcasting station is outputted by supplying the detected frequency data CHs to the local oscillator 12, thus generating an intermediate frequency signal by performing the aforementioned mixing detection using the mixing detector 13.

Moreover, the controller 200, upon being specified by a user to perform an automatic tuning (selection of broadcasting stations) and upon receiving a specifying signal SE1 from the operating unit 100, supplies the control signal SW to the tap coefficient updating unit 25, stops the variable control of tap coefficients $K_0(t-1)$-$K_m(t-1)$ , and performs a seeking control on the local oscillator 12, thereby effecting an automatic tuning (selection of broadcasting stations).

Namely, once the seeking control is started to change the reception frequency (in other words, tuning frequency), the controller 200 operates to have the tap coefficients $K_0(t-1)$ - $K_m(t-1)$ fixed at values immediately before the starting of the seeking control, thus allowing the local oscillator 12 to output a local oscillation signal $f_c$ having a continuously changing frequency. Then, once the amplitude of the field strength detection signal Es outputted from the field strength detector 16 reaches a predetermined level, it can be determined that the reception sensitivity is acceptable, and the frequency of the local oscillation signal $f_c$ at this time is stored in a memory or the like, thereby performing an automatic tuning.

Subsequently, once the seeking control within a predetermined frequency band is completed, the controller 200 will terminate the seeking control, and at the same time supply the control signal SW to the tap coefficient updating unit 25, thereby restarting the variable control of the tap coefficients $K_0(t-1)$ - $K_m(t-1)$.

In this way, during the seeking control, by fixing the tap coefficients $K_0(t-1)$ - $K_m(t-1)$ and by maintaining the filter characteristics of the multipass removal filter 20 at certain constant values, it is possible to stabilize the multipass removal filter 20 and prevent an error signal from being supplied to the FM detector.

An operation of the present receiver will be briefly described as follows.

During a radio reception not involving an automatic tuning, the local oscillator 12 outputs a local oscillation signal $f_c$ of a broadcasting station or the like specified by a user, while the mixing detector 13 performs the aforementioned mixing detection, thus allowing the A/D converter 15 to output an intermediate frequency signal DIF consisting of a digital data sequence.

Then, the intermediate frequency signal DIF is processed by the field strength detector 16 to generate a field strength signal Es, while a local oscillation signal $f_c$ having an acceptable tuning characteristic is outputted by virtue of the PLL circuit contained in the local oscillator 12.

Further, the intermediate frequency signal DIF is processed by the amplitude adjuster 18 to be synchronous with the adjusting period $\tau$ and adjusted to a certain amplitude, while the adjusted intermediate signal is outputted as an input signal $X_{in}(t)$ to be inputted into the multipass removal filter 20. Moreover, the amplitude supervisor 19 supervises the amplitude of the input signal $X_{in}(t)$ . In this way, once the change rate of the amplitude exceeds a predetermined value described with reference to Fig. 3, the amplitude adjuster 18 will be controlled and the adjusting period $\tau$ will be changed, thereby increasing the follow-up speed of the amplitude adjuster 18 with respect to the intermediate frequency signal DIF.

Therefore, even when the intermediate frequency signal DIF is rapidly changed under an influence of radio reception environment, the amplitude adjuster 18 can follow such change, so as to supply an input signal $X_{in}(t)$ having a constant amplitude to the multipass removal filter 20, thereby ensuring a function of stabilizing the multipass removal filter 20.

The multipass removal filter 20 receives the above-mentioned input signal $X_{in}(t)$ , generates a desired signal Y (t) not containing a multipass distortion, and outputs the same towards an FM detector.

Furthermore, the error component restricting section 24 shown in Fig. 2 generates a corrected error component $e_{cp}(t)$, while the tap coefficient updating unit 25 performs a variable control of the tap coefficients $K_0(t-1)$ - $K_m(t-1)$ in accordance with the corrected error component $e_{cp}(t)$ so as to stabilize the digital filter 21. Therefore, even if a changing input signal $X_{in}(t)$ is outputted from the above-mentioned amplitude adjuster 18, it is still possible to quickly stabilize the multipass removal filter 20, appropriately generate the desired signal Y(t) and output the same towards an FM detector.

Next, during an automatic tuning, once there is an instruction from a user specifying a start of an automatic tuning, the controller 200 will perform a control on the tap coefficient updating unit 25 so as to stop the variable control of the tap coefficients $K_0(t-1)$ - $K_m(t-1)$ . Meanwhile, the controller 200 controls the local oscillator 12 to continuously and rapidly change the frequency of the local oscillation signal $f_c$.

Then, the mixing detector 13 performs a mixing detection in accordance with the local oscillation signal $f_c$ having a changing frequency, thereby allowing the A/D converter 15 to output an intermediate frequency signal DIF consisting of a digital data sequence.

Then, the intermediate frequency signal DIF is processed by the field strength detector 16 to generate a field strength signal Es, while a local oscillation signal $f_c$ having an acceptable tuning characteristic is outputted by virtue of the PLL circuit contained in the local oscillator 12.

Further, the intermediate frequency signal DIF is processed by the amplitude adjuster 18 to be synchronous with the adjusting period τ and adjusted to a certain amplitude, while the adjusted intermediate frequency signal is outputted as an input signal $X_{in}$ (t) to be inputted into the multipass removal filter 20. Moreover, the amplitude supervisor 19 supervises the amplitude of the input signal $X_{in}(t)$. In this way, once the change rate of the amplitude exceeds the predetermined value described with reference to Fig. 3, the amplitude adjuster 18 will be controlled and the adjusting period τ will be changed, thereby increasing the follow-up speed of the amplitude adjuster 18 with respect to the intermediate frequency signal DIF.

Therefore, when the local oscillation signal $f_c$ is changed for seeking control, even if the intermediate frequency signal DIF is rapidly changed under an influence of a radio reception environment, the amplitude adjuster 18 can follow such change, so as to supply an input signal $X_{in}(t)$ having a constant amplitude to the multipass removal filter 20, thereby ensuring a function of stabilizing the multipass removal filter 20.

Thus, the multipass removal filter 20 receives the above-mentioned input signal $X_{in}$ (t), generates a desired signal Y (t) not containing a multipass distortion, and outputs the same towards an FM detector.

Furthermore, during an automatic tuning, since the tap coefficients $K_0(t-1)$ - $K_m(t-1)$ are fixed, the multipass removal filter 20 will be in a stabilized condition. Accordingly, even if a changing input signal $X_{in}(t)$ is outputted from the above-mentioned amplitude adjuster 18, it is still possible for the multipass removal filter 20 to generate the desired signal Y(t) appropriately and output the same towards an FM detector.

As described above, in use of the receiver formed according to the present embodiment, even if there is an influence from a radio reception environment and another influence from an automatic tuning and even if these influences will cause a change in the intermediate frequency signal DIF outputted from the A/D converter 15, the adjusting period τ of the amplitude adjuster 18 will change under the control of the amplitude supervisor 19 to follow up the change of the intermediate frequency signal DIF. Therefore, the input signal $X_{in}(t)$ having a constant amplitude can be supplied to the multipass removal filter 20, making it possible to stabilize the multipass removal filter 20.

Further, since the multipass removal filter 20 is provided with the error component restricting section 24, even if there will be a change in the input signal $X_{in}(t)$, such an input signal can be converged in a stabilized direction.

Moreover, during an automatic tuning, since the tap coefficients $K_0(t-1)$ - $K_m$ (t-1) are fixed and the multipass removal filter 20 is stabilized, even if during a seeking control the changing input signal $X_{in}(t)$ is inputted into the multipass removal filter 20, it is still possible for the multipass removal filter 20 to appropriately generate the desired signal Y(t) and output the same to the FM detector side.

In addition, although the above-described preferred embodiment is based on a receiver equipped with the multipass removal filter 20 shown in Fig. 2, it is also possible to utilize a different multipass filter having a different constitution.

For example, although, for the purpose of ensuring an adequate stability, the multipass removal filter 20 shown in Fig. 2 is provided with the error component inhibiting section 24 including the absolute value detecting circuit 24a, the digital low-pass filter 24b, the amplitude controlling circuit 24c, and the amplitude restricting circuit 24d, it is also possible to omit such an error component inhibiting section 24, thereby supplying an error component e(t) outputted from the subtracter 23c, rather than supplying a corrected error component $e_{cp}(t)$, to the tap coefficient updating unit 25.

Although, according to such an arrangement, the corrected error component $e_{cp}(t)$ shown in the above equation (1) will be replaced by an error component e (t) and this allows the error component e (t) to be directly applicable to the equation (1), it is still possible to stabilize the digital filter 21 since the tap coefficients $K_0(t-1)$ - $K_m(t-1)$ are fixed by the tap coefficient updating unit 25 during an automatic tuning.

Further, according to such an arrangement, during a radio reception not involving an automatic tuning, the corrected error component $e_{cp}(t)$ shown in the above equation (1) will be replaced by an error components (t). This is because during a radio reception not involving an automatic tuning, there is an extremely strong control in which the adjusting period τ of the amplitude adjuster 18 will change under the control of the amplitude supervisor 19 to follow up the change of the intermediate frequency signal DIF. Therefore, it is possible to supply the input signal $X_{in}(t)$ having a constant amplitude to the multipass removal filter 20. In addition, since it is almost impossible for the input signal $X_{in}(t)$ to have any change, there would be no problem in an actual use.

Moreover, according to the above description of the present embodiment, during an automatic tuning, once the controller 200 causes, in accordance with the signal SW, the tap coefficient updating unit 25 to stop the variable control of the tap coefficients $K_0(t-1)$ - $K_m(t-1)$, the tap coefficient updating unit 25 will operate to fix these coefficients at the latest $K_0$ (t-1) - $K_m(t-1)$ values variably controlled thus far. However, it is also possible for these coefficients to be fixed at tap coefficients $K_0(t-1)$ - $K_m(t-1)$ found experimentally for stabilizing the digital filter 21, rather than being fixed at the latest tap coefficients $K_0$ (t-1) - $K_m(t-1)$.

Besides, it is further possible to change the tap coefficient changing algorithm in a manner such that a tap coefficient $K_j(t-1)$ shown as the first item on the right hand side of the above equation (1) is multiplied by a variable γ, while the tap coefficient updating unit 25 operates to variably control the variable γ, in response to a change in the above-mentioned corrected error component $e_{cp}(t)$ or the error component $e(t)$

According to such an arrangement, even if there is a possibility that the operation of the digital filter 21 will become unstable because of an influence from multipass, it is still possible to quicken the velocity of converging a corrected error component $e_{cp}(t)$ or an error component $e(t)$ to almost zero, in response to the value of the variable $\gamma$. Therefore, it is possible to realize a multipass removal filter which is strong (robust) and stable with respect to the multipass.

## Claims

1. A receiver comprising;

   - a front end unit (11) for mixing/detecting, in accordance with a local oscillation signal, a high frequency received signal received by a reception antenna, thus outputting an intermediate frequency signal;
   - an A/D converter (15) for analog-digital converting the intermediate frequency signal, thereby outputting a digital intermediate frequency signal; and
   - an amplitude adjuster (18) for adjusting the amplitude of the digital intermediate frequency signal to a predetermined value and then , outputting the digital intermediate frequency signal;

   **characterized by** further comprising:

   - a multipass removal filter (20) for removing a multipass distortion of a signal outputted from the amplitude adjuster and then outputting the signal; and
   - an amplitude supervisor (19) for supervising a change in the signal outputted from the amplitude adjuster (18), and changing an adjusting period of the amplitude adjuster (18) once the change exceeds a predetermined value.

2. A receiver according to claim 1, **characterized by** further comprising:

   a controller (200) for continuously changing the frequency of the local oscillation signal, thereby performing an automatic tuning, wherein the controller (200) operates to fix tap coefficients of the multipass removal filter (20) during the automatic tuning.

## Patentansprüche

1. Empfänger, der Folgendes aufweist:

   - eine Vorderendeinheit (11), um in Abhängigkeit von einem Überlagerersignal ein von einer Empfangsantenne empfangenes HF-Empfangssignals zu mischen/detektieren und somit ein ZF-Signals auszugeben;
   - einen A/D-Umsetzer (15) zur Analog-Digital-Umsetzung des ZF-Signals, wodurch ein digitales ZF-Signal ausgegeben wird; und
   - eine Amplitudeneinstelleinrichtung (18) zum Einstellen der Amplitude des digitalen ZF-Signals auf einen vorbestimmten Wert und anschließenden Ausgeben des digitalen ZF-Signals;

   **dadurch gekennzeichnet, das** er ferner Folgendes aufweist:

   - ein Mehrfachdurchgangsentfernungsfilter (20) zum Entfernen einer Mehrfachdurchgangsverzerrung eines von der Amplitudeneinstelleinrichtung ausgegebenen Signals und anschließenden Ausgeben des Signals; und
   - eine Amplitudenüberwachungseinrichtung (19) zum Überwachen einer Änderung des von der Amplitudeneinstelleinrichtung (18) ausgegebenen Signals und Ändern einer Einstellperiode der Amplitudeneinstelleinrichtung (18), nachdem die Änderung einen vorbestimmten Wert überschritten hat.

2. Empfänger nach Anspruch 1, **dadurch gekennzeichnet, dass** er ferner Folgendes aufweist:

   eine Steuereinheit (200) zum kontinuierlichen Ändern der Frequenz des Überlagerersignals, wordurch eine automatische Abstimmung ausgeführt wird, wobei die Steuereinheit (200) wirksam ist, um Abgriffkoeffizienten des Mehrfachdurchgangsentfernungsfilters (20) während der automatischen Abstimmung festzulegen.

**Revendications**

1. Récepteur comprenant ;

   - une unité de tête radiofréquence (11) destinée à mélanger /détecter, selon un signal d'oscillation locale, un signal reçu à haute fréquence par une antenne de réception, en délivrant de ce fait en sortie un signal de fréquence intermédiaire ;
   - un convertisseur A / N (15) destiné à convertir de manière analogique - numérique le signal de fréquence intermédiaire, en délivrant de ce fait en sortie un signal de fréquence intermédiaire numérique ; et
   - un dispositif de réglage d'amplitude (18) destiné à régler l'amplitude du signal de fréquence intermédiaire numérique à une valeur prédéterminée et ensuite à délivrer en sortie le signal de fréquence intermédiaire numérique ;

   **caractérisé en ce qu'**il comprend en outre :

   - un filtre de suppression multipassage (20) destiné à supprimer une distorsion multipassage d'un signal délivré en sortie par le dispositif de réglage d'amplitude et ensuite à délivrer en sortie le signal ; et
   - un dispositif de surveillance d'amplitude (19) destiné à surveiller un changement du signal délivré en sortie par le dispositif de réglage d'amplitude (18), et à changer une période de réglage du dispositif de réglage d'amplitude (18) lorsque le changement dépasse une valeur prédéterminée.

2. Récepteur selon la revendication 1, **caractérisé en ce qu'**il comprend en outre :

   un contrôleur (200) destiné à changer de manière continue la fréquence du signal d'oscillation locale, en exécutant de ce fait un accord automatique, dans lequel le contrôleur (200) fonctionne de manière à fixer des coefficients de prise du filtre de suppression multipassage (20) au cours de l'accord automatique.

## FIG.1

FIG.1 — Block diagram. Antenna (ANT) → HIGH FREQUENCY AMPLIFIER (10) → MIXING-DETECTOR (13) with LOCAL OSCILLATOR (12) (fc), both within block (11) → IF AMPLIFIER (14) (SIF) → A/D CONVERTER (15) (DIF) → PRE-ADJUSTING UNIT (17): AMPLITUDE ADJUSTER (18) and AMPLITUDE SUPERVISOR (19) (Gv), producing Xin(t) → MULTIPASS REMOVAL FILTER (20) → Y(t) (TO DETECTOR). FIELD STRENGTH DETECTOR (16) outputs Es. CONTROLLER (200) connected via SW, SEL, CHs, Es. OPERATING UNIT (100).

## FIG.2

*FIG.3 A*

ADJUSTING PERIOD $\tau$

RATE OF CHANGE $\left( \dfrac{dXev(t)}{dt} \right)$

*FIG.3 B*

ADJUSTING PERIOD $\tau$

RATE OF CHANGE $\left( \dfrac{dXev(t)}{dt} \right)$

*FIG.3C*

ADJUSTING PERIOD $\tau$

RATE OF CHANGE $\left( \dfrac{dXev(t)}{dt} \right)$

13

## FIG.4

EP 1 538 750 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6002925 A